Europäisches Patentamt

European Patent Office

Office européen des brevets

(11) Publication number: **0 562 601 A1**

# EUROPEAN PATENT APPLICATION

(21) Application number: **93104942.3**

(22) Date of filing: **25.03.93**

(51) Int. Cl.5: **H01L 39/24**

(30) Priority: **27.03.92 JP 70604/92**

(43) Date of publication of application:
**29.09.93 Bulletin 93/39**

(84) Designated Contracting States:
**DE FR GB NL**

(71) Applicant: **HITACHI, LTD.**
**6, Kanda Surugadai 4-chome**
**Chiyoda-ku, Tokyo 101(JP)**

(72) Inventor: **Nabatame, Toshihide**
**Ushimaki Danchi 6-908, 3-18 Ushimaki**
**Mizuho-ku, Nagoya-shi(JP)**

Inventor: **Saito, Yukio**
**5-6, Moriyamacho-1-chome**
**Hitachi-shi(JP)**
Inventor: **Kamo, Tomoichi**
**60-7, Suwamaminamidai, Tokaimura**
**Naka-gun, Ibaraki-ken(JP)**
Inventor: **Doi, Toshiya**
**17-1-302, Moriyamacho-3-chome**
**Hitachi-shi(JP)**

(74) Representative: **Patentanwälte Beetz - Timpe -**
**Siegfried - Schmitt-Fumian- Mayr**
**Steinsdorfstrasse 10**
**D-80538 München (DE)**

(54) **Oxide superconductors.**

(57) The oxide superconductor of a layered perovskite structure is derived from a starting superconductor having a basic composition by substituting for one or more constituents of the basic composition, elements having a smaller ionic radius than that of the constituents, so that the longest distance d between the Cu-O planes of the oxide superconductor derived is smaller than the longest distance $d_0$ between the Cu-O planes of the starting superconductor. The longest distance d between the Cu-O planes of the oxide superconductor of the present invention is in the range of not less than 0.3 nm but less than 0.9 nm ($0.3 \text{ nm} \leq d < 0.9 \text{ nm}$). Use of the oxide superconductor having an element having a smaller ionic radius substituted for part of the elements thereof as a raw material can manufacture a wire or thin film having a high Jc value in a magnetic field.

F I G. I

M = Li, Na, Be, Mg, Sc, Y, La, Ce, Pr, Nd, Pm, Sm, Eu, Gd, Tb,
   Dy, Ho, Er, Tm, Yb, Lu, Ag, Pt, Pd, Ni
N = In, Ga, Al, Sn, Ge, Si, Sb, As

Rank Xerox (UK) Business Services
(3.10/3.6/3.3.1)

## BACKGROUND OF THE INVENTION

### FIELD OF THE INVENTION

The present invention relates to an oxide superconductor, more particularly to an oxide superconductor capable of having a high critical current density when placed in a magnetic field.

### DESCRIPTION OF RELATED ART

A superconducting material transfers to a superconducting condition and allows an electric current to flow therethrough at a current density of not more than the critical current density Jc under a resistance of zero (0), when the material is cooled to a temperature T of not higher than the critical temperature Tc. Under such conditions, as a magnetic field H externally applied to the superconducting material is increasing, the upper limit of the current density Jc under a resistance of zero (0) is decreasing and eventually Jc becomes equal to zero (0). The magnetic field at this stage is referred to as an "irreversible field" and designated as "H*" in the present invention.

Layered perovskite-type oxide superconductors of an Y-Ba-Cu-O system, Bi(Pb)-Sr-Ca-Cu-O system, Tl(Pb)-Sr-Ca-Cu-O system and Tl-Ba-Ca-Cu-O system have a critical temperature (Tc) above the temperature of liquid nitrogen boiling point (77K). Therefore, in an economical point of view, it is permissible to prepare superconductor magnets, coils, electronic devices, etc. used under cheaper liquid nitrogen as refrigeration medium, from the oxides. Great future development of this field is expected. The superconducting magnets and coils are strongly required to have a high critical current density (Jc).

It is well known from Proceedings of the 3rd International Symposium on Superconductivity (ISS '90) Nos. 6-9, 1990, pp. 555-558 that the magnitude of Jc of oxide superconductors in magnetic field depends particularly upon the component of magnetic field in a direction parallel to the c-axis of the crystal structure of the superconductors in a magnetic field applied to the superconductors. Furthermore, Physica C, Vol. 177, 1991, pp. 431-437 teaches that, with layered perovskite-type oxide superconductors containing Cu-O planes, a magnetic field applied in a direction parallel to the c-axis of the crystal regulates the magnitude of a current flowing through the superconductors under a resistance of zero (0), and the shorter the maximum distance d between the Cu-O planes of the crystal, the more easily the current flowing through the superconductor under a resistance of zero (0) can be secured. That is, the magnitude of Jc of a supercondutor in a magnetic field is strongly ruled by H* in a direction parallel to the c-axis, and a superconductor having a shorter length of the maximum distance d between the Cu-O planes has a higher value of H* in a direction parallel to the c-axis.

This distance d depends upon the crystal structure of the oxide superconductor and is linearly determined when the oxide superconductor is constituted by basic constituent elements. For example, the d value is 0.83 nm for $Y_1Ba_2Cu_3O_7$, 0.87 nm for $(Tl_{0.5}Pb_{0.5})_1Sr_2Ca_2Cu_3O_9$, 0.96 nm for $Tl_1Ba_2Ca_2Cu_3O_9$, 1.14 nm for $Tl_2Ba_2Ca_2Cu_3O_{10}$, and 1.21 nm for $(Bi/Pb)_2Sr_2Ca_2Cu_3O_{10}$. This is seen from Nature, Vol. 327, 1987, pp. 687-689, Physica C Vol. 159, 1989, pp. 245-, Physical Review B, Vol. 38, 1988, pp. 6624-6630, Physica C, Vol. 177, 1991, pp. 431-437, and Physica C, Vol. 157, 1989, pp. 495-.

It is known that oxide superconductors are relatively flexible and remain to be superconducting even when subjected to the elemental substitution. For example, it is seen from Japanese Patent Kokai (Laid-Open) No. 64-61346 that in oxides of a Ln-M-Cu-O system, wherein Ln is Sc, Y or one of lanthanoid elements and M is Ba or Sr, any of Li, K and Na can be substituted for part of M, and from Japanese Patent Kokai (Laid-Open) No. 1-305816 that in oxides of $TlCa_xBa_2Cu_{x+1}O_y$ and $Tl_2Ca_xBa_2Cu_{x+1}O_y$, In, Ga, Sb and/or Bi can be substituted for Tl.

The prior art oxide superconductors above have the respective specific distance d depending upon the crystal structure. Therefore, the oxide superconductors do not have an adequately high irreversible magnetic field H*. Generally, a high H* value is required by the practical use of oxide superconductors as a magnet, etc. in a high magnetic field. However, since the prior art oxide superconductors have the specific distance d, it is very difficult to obtain the high H* value. Therefore, wires formed of the prior art oxide superconductors have a low Jc in a magnetic field.

### SUMMARY OF THE INVENTION

It is a primary object of the present invention to provide an oxide superconductor having a high H* value with a distance d being reduced.

It is another object of the present invention to provide a superconducting wire having a high Jc value in a magnetic field from the oxide superconductor.

It is a still further object of the present invention to provide a device with the oxide superconductor or superconducting wire.

BRIEF DESCRIPTION OF THE DRAWINGS

Fig. 1 is a model of the crystal structure of a $(Tl_{1-x}Pb_x)_1(Sr_{1-p}M_p)_2Ca_2Cu_3O_z$ superconductor according to the present invention.

Fig. 2 is a graph showing the relationship between the distance d and H* of the basic compositions of supercondutors.

Fig. 3 is a model of the crystal structure of a $(Bi_{1-x}Pb_x)_2(Sr_{1-p}M_p)_2Ca_2Cu_3O_z$ superconductor according to the present invention.

Fig. 4 is a model of the crystal structure of a $Tl_1(Ba_{1-p}M_p)_2Ca_2Cu_3O_z$ according to the present invention.

Fig. 5 is a model of the crystal structure of a $Tl_2(Ba_{1-p}M_p)_2Ca_2Cu_3O_z$ according to the present invention.

Fig. 6 is a schematical view of a dc-SQUID according to the present invention.

Figs. 7a and 7b are a schematical view of a $\mu$-wave responding device.

Fig. 8 is a schematical cross-sectional view of a superconducting wire using the superconductor according to the present invention.

Fig. 9 is a schematical view of a superconducting coil manufactured from the superconducting wire using the superconductor according to the present invention.

Fig. 10 is a schematical view of a device using the superconducting coil as shown in Fig. 9.

DETAILED DESCRIPTION OF THE PREFERRED EMBODIMENTS

When wires are to be actually manufactured from oxide superconductors, the oxide superconductors must be in a polycrystalline form. Therefore, taking an account of the actual application of oxide superconductors to wires or coils, the properties of the crystal boundaries formed between the crystal grains of the oxide superconductor as well as the properties of the oxide superconductor are very important. In other words, not only the Jc or H* within the crystal grains of an oxide superconductor but also a magnitude of a superconducting current flowing over the boundaries between the crystal grains are important. In the present invention, it is a measure that a superconductor having a magnitude of an intergranular superconducting current of one-fifth (1/5) or less of the intergranular Jc value at 77 K and 1 T is not an effective material for practical use.

The objects above can be achieved by substituting elements for at least part of elements occupying sites between a Cu-O plane and another Cu-O plane at the longest distance from the former Cu-O plane, the former elements having a lower ionic radius than that of the latter elements. In other words, the oxide superconductor of the present invention is derived from a starting superconductor having a basic composition by substituting for one or more constituents of the basic composition, elements having a smaller ionic radius than that of the constituents, so that the longest distance d between the Cu-O planes of the oxide superconductor derived is smaller than the longest distance $d_0$ between the Cu-O planes of the starting superconductor. The longest distance d between the Cu-O planes of the oxide superconductor of the present invention is in the range of not less than 0.3 nm but less than 0.9 nm (0.3 nm ≤ d < 0.9 nm). Use of the oxide superconductor having an element having a smaller ionic radius substituted for part of the elements thereof as a raw material can manufacture a wire or thin film having a high Jc value in a magnetic field.

However, all the elements having a smaller ionic radius cannot be used, but an element of a superconductor and a substituent for the element should have affinity for each other. The present inventors studied on what elements can be substituted for the elements of various oxide superconductors to obtain oxide superconductors having a high value of H*. As a result, they have found that the following combinations of elements can provide oxide superconductors having a high value of H*:

Substituents for Sr of $(Tl_{1-x}Pb_x)-Sr_2-Ca_y-Cu_{y+1}-O_z$ (0<x<1, 0≦y≦3 and 3+2y<z<4+2y) and $(Bi_{1-x}Pb_x)_2-Sr_2-Ca_y-Cu_{y+1}-O_z$ (0<x<1, 0≦y≦2 and 5+2y<z<7+2y) may suitably be an alkali metal such as Li and Na, an alkaline earth metal such as Be and Mg, a metal of Group IIIa, such as Sc, Y and Ln (lanthanoid), and Ag, Pt, Pd and Ni; substituents for Ba of $Tl_1-Ba_2-Ca_y-Cu_{y+1}-O_z$ (0≦y≦3 and 3+2y<z<4+2y) and $Tl_2-Ba_2-Ca_y-Cu_{y+1}-O_z$ (0≦y≦3 and 5+2y<z<7+2y) may suitably be an alkali metal such as Li and Na, an alkaline earth metal such as Be, Mg and Sr, a metal of Group IIIa, such as Sc, Y and Ln (lanthanoid), and Ag, Pt, Pd and Ni; substituents for Tl or Pb of $(Tl_{1-x}Pb_x)$-$Sr_2$-$Ca_y$-$Cu_{y+1}$-$O_z$ ($0<x<1$, $0\leqq y\leqq 3$ and $3+2y<z<4+2y$), $Tl_2$-$Ba_2$-$Ca_y$-$Cu_{y+1}$-$O_z$ ($0\leqq y\leqq 3$ and $5+2y<z<7+2y$) and $T_2$-$Ba_2$-$Ca_y$-$Cu_{y+1}$-$Oz$ ($0\leqq y\leqq 3$ and $5+2y<z<7+2y$) may suitably be a metal of Group IIIa, such as In, Ga and Al, a metal of Group IVb, such as Sn, Ge and Si and a metal of Group Vb, such as Sb and As.

The proportion of substitution should not be limited to the range of solid dissolution of the substituents for the elements of the superconductors, because there occur no practical problems even if such an excess of the substituents that they cannot form any solid solution are precipitated as foreign phase, if such a foreign phase does not inhibit the crystals of the superconductor from making an electrically good bonding to each other. According to our experience, the Jc value in a magnetic field begins suddenly to lower when the proportion of substitution exceeds 30%. Preferably, the substitution is made at a rate of 1 to 30%.

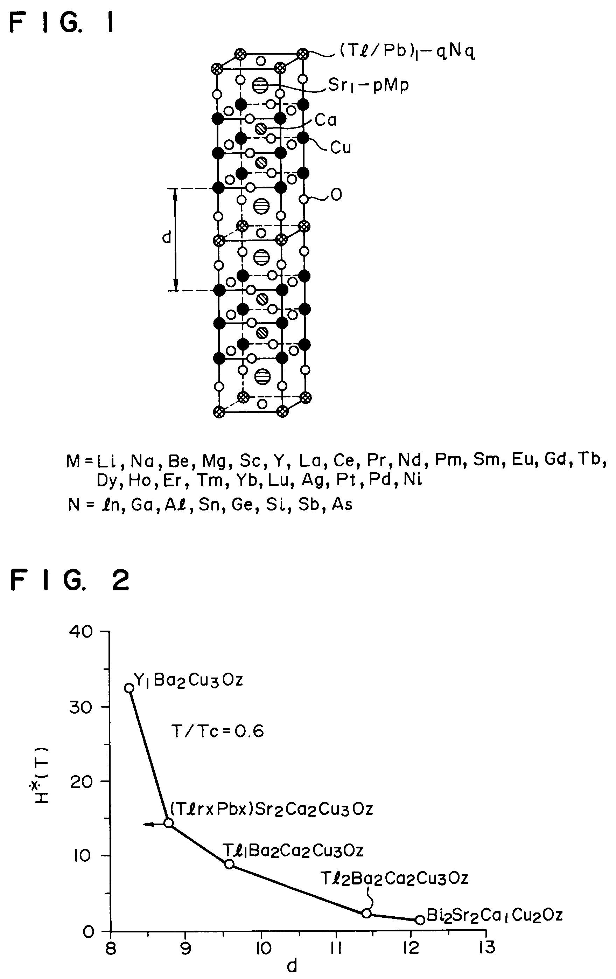

The term "Cu-O plane" used herein is a crystal plane consisting of copper and oxygen and understood from the model of crystal structure as shown, for example, in Fig. 1. Fig. 1 shows two unit crystal cells stacked in the direction of c-axis. The crystal structure of superconductor as shown in Fig. 1 comprises ... $(Tl/Pb)_{1-q}N_q$-O plane, $Sr_{1-p}M_p$-O plane, Cu-O plane, Ca plane, Cu-O plane, Ca plane, Cu-O plane, $Sr_{1-p}M_p$-O plane, $(Tl/Pb)_{1-q}N_q$-O plane, $Sr_{1-p}M_p$-O plane, Cu-O plane, Ca plane, Cu-O plane, Ca plane, Cu-O plane, $Sr_{1-p}M_p$-O plane, $(Tl/Pb)_{1-q}N_q$-O plane, ... periodically repeated in the stack of the planes in the direction of c-axis.

The term "distance between Cu-O planes" used herein is the longest one of the distances between some Cu-O planes in the repeated planes, i.e., designated as "d" in Fig. 1.

The term "irreversible magnetic field H*" used herein is a minimum magnetic field at which a magnetic flux entering the interior of a superconductor begins to move when a magnetic field externally applied to the superconductor is allowed to increase at a certain temperature. There are various methods of determining such a minimum magnetic field. In the present invention, the minimum magnetic field for a superconductor is determined by observing the temperature at which a resistance gets zero (0) under a microcurrent allowed to flow through the superconductor, while changing the magnitude of magnetic field applied. The minimum magnetic field is the irreversible magnetic field H* at the temperature.

The H* value of a superconductor being high means that the superconductor is tough to a magnetic field. Such a superconductor has a high critical current density in a magnetic field. The higher the critical temperature of a superconductor, the larger the difference in energy between the superconducting state and the normally conducting state of the superconductor when used at a temperature. Therefore, the superconducting state is more stable and the critical current density is larger.

A magnet made of a normal copper wire does not hardly generate a magnetic field of up to 1 tesla. A magnet made of a superconducting wire is advantageous when a magnetic field exceeding 1 tesla is required.

According to the present invention, with oxide superconductors of a layered perovskite type containing Cu-O planes, the distance d between Cu-O planes can be shortened by substituting an alkali metal, such as Li of 0.078 nm in ionic radius and Na of 0.098 nm, an alkaline earth metal, such as Be of 0.034 nm and Mg of 0.078 nm, a Group IIIa metal, such as Sc of 0.083 nm, Y of 0.106 nm and lanthanoids of from 0.099 to 0.137 nm, and Ag of 0.113 nm, Pt of 0.053 nm, Au of 0.137 nm, Pd of 0.050 nm and Ni of 0.078 nm, for part of Sr of 0.127 nm and/or Ba of 0.143 nm occupying the sites between the Cu-O planes. As a result, the H* value in the direction of c-axis can be increased. Furthermore, the distance d between Cu-O planes can be shortened by substituting a Group IIIb metal, such as Sn of 0.074 nm, Ge of 0.044 nm and Si of 0.039 nm, a Group IVb metal, such as In of 0.092 nm, Ga of 0.062 nm and Al of 0.057 nm, and a Group IIIb metal, such as Sb of 0.090 nm and As of 0.069 nm, for part of Tl of 0.106 nm, Pb of 0.132 nm and/or Bi of 0.120 nm occupying the sites between the Cu-O planes. As a result, the H* value in the direction of c-axis can be increased. Furthermore, using these small-in-ionic radius ion-substituted oxide superconductors as a superconducting wire can provide a wire improved in the critical current density Jc in a magnetic field due to the high H* of the superconductor as raw material.

The superconducting wire made from the superconductor according to the present invention makes it possible to manufacture a good superconducting magnet working when cooled with liquid nitrogen. This magnet is operable in various apparatuses or devices such as NMR, SQUID, MRI, magnetic levitation vehicles and etc. For all apparatuses or devices using a superconducting magnet can be used the superconductor according to the present invention and hence these apparatuses or devices are operable with liquid nitrogen. The operation of apparatuses or devices with liquid nitrogen does not only advantageously lower the running costs due to a difference in price between liquid helium and liquid nitrogen, but also lowers a cost for securing the reliability of the apparatuses or devices (otherwise costs of various treatments for inhibiting a so-called quenching by which the superconductivity is lost would be incurred), a running cost of a refrigerator and an insulating cost to a larger extent. Therefore, the price of superconducting apparatuses or devices using the superconducting wire or coil according to the present invention can be lowered to a large extent.

The present invention will be illustrated below by some examples with reference to some drawings attached hereto.

Example 1

The model of the crystal structure of a superconductor represented by $(Tl_{1-x}Pb_x)I(Sr_{1-p}M_p)_2Ca_2Cu_3O_z$ is shown in Fig. 1. The longest distance between Cu-O planes is designated as d in Fig. 1. The superconductor was prepared in the following procedures. Basic constituent elements: $Tl_2O_3$, PbO, SrO, CaO and CuO and a substituent M: $Li_2O$, $Na_2O$, BeO, MgO, $Sc_2O_3$, $Y_2O_3$, $La_2O_3$, $Ce_2O_3$, $Pr_2O_3$, $Nd_2O_3$, $Pm_2O_3$, $Sm_2O_3$, $Eu_2O_3$, $Gd_2O_3$, $Tb_2O_3$, $Ho_2O_3$, $Er_2O_3$, $Tm_2O_3$, $Yb_2O_3$, $Lu_2O_3$, $Ag_2O$, Pt, Pd or Ni were formulated at a $(Tl_{1-x}Pb_x):(Sr_{1-p}M_p):Ca:Cu$ ratio of 1:2:2:3, wherein x = 0.05, 0.1, 0.2, 0.3, 0.4, 0.5, 0.6, 0.7, 0.8, 0.9 or 1.0 and p = 0, 0.05, 0.1, 0.2, 0.3, 0.4 or 0.5. The thus obtained formulations were mixed in an attrition mill and pelletized. The resultant pellets were heat treated in air at 840-950°C for 10-50 hours to obtain superconductor powders. The observation of the powders by an X-ray diffraction analysis revealed that an amount of foreign phases having unidentified peaks increased as the p value was raised but a major amount of crystals was the same Tl-(1223) phase as shown in Fig. 1. Furthermore, the measurements of resistance by a usual four-terminal method revealed that Tc ranged from 88-120 K for all the powders.

For a $(Tl_{1-x}Pb_x)_1(Sr_{1-p}M_p)_2Ca_1Cu_2O_z$ superconductor, wherein substituent M was the same element as mentioned above, the same heat treatment as mentioned above resulted in the formation of a superconductor containing a major amount of the same crystal structure as $T_1Sr_2CaCu_2O_7$ and having a Tc of 70-90 K.

For a $(Tl_{1-x}Pb_x)_1(Sr_{1-p}M_p)_2Cu_1O_z$ superconductor, wherein substituent M was the same element as mentioned above, the same heat treatment as mentioned above resulted in the formation of a superconductor containing a major amount of the same crystal structure as $(Tl_{0.5}Pb_{0.5})Sr_2CuO_5$ and having a Tc of 40-80 K.

For a $(Tl_{1-x}Pb_x)_1(Sr_{1-p}M_p)_2Ca_3Cu_4O_z$ superconductor, wherein substituent M was the same element as mentioned above, the same heat treatment as mentioned above resulted in the formation of a superconductor containing a major amount of the same crystal structure as $T_1Sr_2Ca_3Cu_4O_{11}$ and having a Tc of 70-120 K.

On the other hand, a $((Tl_{1-x}Pb_x)_{1-q}N_q)_1Sr_2Ca_2Cu_3O_z$ superconductor was prepared by formulating basic constituents: $Tl_2O_3$, PbO, SrO, CaO and CuO and a substituent N: $Sb_2O_3$, $As_2O_3$, $SnO_2$, $GeO_2$, $SiO_2$, $In_2O_3$, $Ga_2O_3$ or $Al_2O_3$ at a (Tl, Pb, N):Sr:Ca:Cu ratio of 1:2:2:3, wherein 0<x<1 and 0<q<1, mixing the formulation in an attrition mill and pelletizing the mixture. These pellets were heat treated in air at 840-950°C for 10-50 hours to obtain the superconductor. The observation of the superconductor by an X-ray diffraction analysis revealed that an amount of foreign phases having unidentified peaks increased as the q value was raised but a major amount of crystals was the same Tl-(1223) phase as shown in Fig. 1. Furthermore, the measurements of resistance by a usual four-terminal method revealed that Tc ranged from 88-120 K for all the powders.

For a $((Tl_{1-x}Pb_x)_{1-q}N_q)_1Sr_2Ca_1Cu_2O_z$ superconductor, wherein substituent N was the same element as mentioned above, the same heat treatment as mentioned above resulted in the formation of a superconductor containing a major amount of the same crystal structure as $T_1Sr_2CaCu_2O_7$ and having a Tc of 70-90 K.

For a $((Tl_{1-x}Pb_x)_{1-q}N_q)_1Sr_2Cu_1O_z$ superconductor, wherein substituent N was the same element as mentioned above, the same heat treatment as mentioned above resulted in the formation of a superconductor containing a major amount of the same crystal structure as $Tl_{0.5}Pb_{0.5}Sr_2CaC_u2O_5$ and having a Tc of 40-80 K.

For a $((Tl_{1-x}Pb_x)_{1-q}N_q)_1Sr_2Ca_3Cu_4O_z$ superconductor, wherein substituent N was the same element as mentioned above, the same heat treatment as mentioned above resulted in the formation of a superconductor containing a major amount of the same crystal structure as $TlSr_2Ca_3Cu_4O_{11}$ and having a Tc of 70-120 K.

Then, a thin film was prepared with a laser vapor deposition method by using as a target a sintered body of a superconductor of $(Tl_{1-x}Pb_x)_1(Sr_{1-p}M_p)_2Ca_2Cu_3O_z$, $(Tl_{1-x}Pb_x)_1(Sr_{1-p}M_p)_2Ca_1Cu_2O_z$, $(Tl_{1-x}Pb_x)_1(Sr_{1-p}M_p)_2Cu_1O_z$, $(Tl_{1-x}Pb_x)_1(Sr_{1-p}M_p)_2Ca_3Cu_4O_z$, $((Tl_{1-x}Pb_x)_{1-q}N_q)_1Sr_2Ca_2Cu_3O_z$, $((Tl_{1-x}Pb_x)_{1-q}N_q)_1Sr_2Ca_1Cu_2O_z$, $((Tl_{1-x}Pb_x)_{1-q}N_q)_1Sr_2Cu_1O_z$ or $((Tl_{1-x}Pb_x)_{1-q}N_q)_1Sr_2Ca_3Cu_4O_z$, wherein M and N were the same substituents as defined above, and x was 0.4, p was 0.2 and q was 0.1. The thin film was deposited on a substrate of MgO (100) at 100°C with a KrF excimer laser light of 248 nm at a laser energy density of 0.3-5 J/cm$^2$, a frequency of 1-10 Hz and a chamber inner pressure of 0.03 torr. The resulting thin film was

5

amorphous. This amorphous thin film was placed within a powder having the same composition as that of the target and heat treated at 810-900°C for 10-70 hours to produce a superconducting thin film. The chemical analysis of this thin film revealed that it had the same composition as that of the target. The observation by X-ray diffraction revealed that the resulting thin films all had the c-axis oriented in a direction normal to the surface of the substrate. The superconducting transition temperature Tc was in the range of 40-120 K.

For each of the superconductors, the distance d from the measurements by X-ray diffraction and the irreversible magnetic field H* at a reduced temperature (T/Tc) of 0.6 are shown in Table 1. The "reduced temperature" is a ratio to the critical temperature Tc of a temperature T obtained from a temperature-dependency of H* measured at an external magnetic field of 7 tesler. The d and H* of some superconductors comprising the basic constituent elements are shown in Fig. 2.

## Table 1

| M | Li | Na | K | Be | Mg | Sc | Y | La |
|---|---|---|---|---|---|---|---|---|
| d (Å) | 7.6 | 8.0 | – | 6.7 | 7.6 | 7.7 | 8.2 | 8.5 |
| H* (T) (T/Tc=0.6) | 60 | 45 | – | 94 | 60 | 56 | 38 | 26 |

| Ce | Pr | Nd | Pm | Sm | Eu | Gd | Tb | Dy | Ho |
|---|---|---|---|---|---|---|---|---|---|
| 8.4 | 8.4 | 8.4 | 8.3 | 8.3 | 8.3 | 8.2 | 8.2 | 8.2 | 8.2 |
| 30 | 30 | 30 | 34 | 34 | 34 | 38 | 38 | 38 | 38 |

| Er | Tm | Yb | Lu | Ag | Pt | Au | Pd | Ni |
|---|---|---|---|---|---|---|---|---|
| 8.1 | 8.1 | 8.1 | 8.0 | 8.3 | 7.2 | – | 7.1 | 7.6 |
| 41 | 41 | 41 | 45 | 34 | 75 | – | 79 | 60 |

| N | In | Ga | Al | Sn | Ge | Si | Sb | As |
|---|---|---|---|---|---|---|---|---|
| d (Å) | 8.5 | 8.2 | 8.1 | 8.3 | 8.0 | 7.9 | 8.4 | 8.1 |
| H* (T) (T/Tc=0.6) | 26 | 38 | 41 | 34 | 45 | 49 | 30 | 41 |

The same results as shown in Table 1 were obtained by alternative film-forming methods: a sputtering method and an MBE method.

Example 2

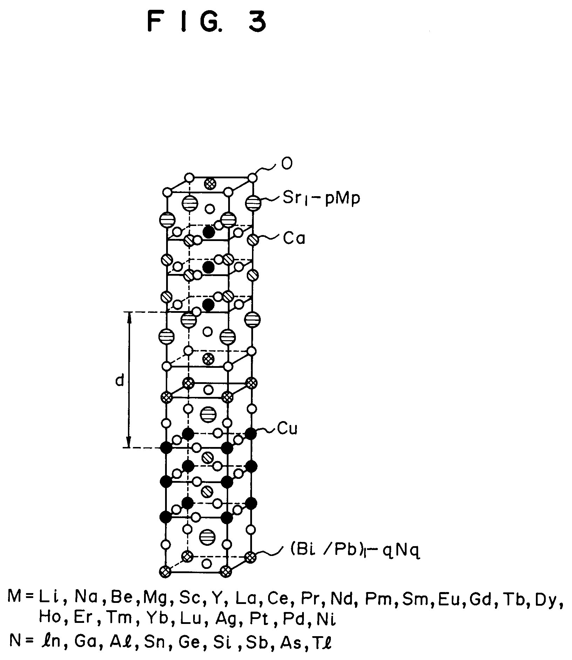

The model of the crystal structure of a superconductor represented by $(Bi_{1-x}Pb_x)_2(Sr_{1-p}M_p)_2Ca_2Cu_3O_z$ is shown in Fig. 3. This superconductor was prepared in the following procedures. Basic constituent elements: $Bi_2O_3$, PbO, SrO, CaO and CuO and a substituent M: $Li_2O$, $Na_2O$, BeO, MgO, $Sc_2O_3$, $Y_2O_3$, $La_2O_3$, $Ce_2O_3$, $Pr_2O_3$, $Nd_2O_3$, $Pm_2O_3$, $Sm_2O_3$, $Eu_2O_3$, $Gd_2O_3$, $Tb_2O_3$, $Ho_2O_3$, $Er_2O_3$, $Tm_2O_3$, $Yb_2O_3$, $Lu_2O_3$, $Ag_2O$, Pt, Pd or Ni were formulated at a $(Bi_{1-x}Pb_x)$: $(Sr_{1-p}M_p)$:Ca:Cu ratio of 2:2:2:3, wherein x is 0.05, 0.1, 0.2, 0.3, 0.4, 0.5, 0.6, 0.7, 0.8, 0.9 or 1.0 and p is 0, 0.05, 0.1, 0.2, 0.3, 0.4 or 0.5. The thus obtained formulations were mixed in an attrition mill and pelletized. The resultant pellets were heat treated in air at 830-850°C for 50-240 hours to obtain superconductor powders. The observation of the powders by an X-ray diffraction analysis revealed that an amount of foreign phases having unidentified peaks increased as the p value was raised but a major amount of crystals was the same Bi-(2223) phase as shown in Fig. 3. Furthermore, the measurements of resistance by a usual four-terminal method revealed that Tc ranged from 78-110 K for all the powders.

For a $(Bi_{1-x}Pb_x)_2(Sr_{1-p}M_p)_2Ca_1Cu_2O_z$ superconductor, wherein substituent M was the same element as mentioned above, the same heat treatment as mentioned above resulted in the formation of a superconductor containing a major amount of the same crystal structure as $Bi_2Sr_2CaCu_2O_8$ and having a Tc of 70-90 K.

For a $(Bi_{1-x}Pb_x)_2(Sr_{1-p}M_p)_2Cu_1O_z$ superconductor, wherein substituent M was the same element as mentioned above, the same heat treatment as mentioned above resulted in the formation of a superconductor containing a major amount of the same crystal structure as $Bi_2Sr_2CuO_6$ and having a Tc of 40-80 K.

On the other hand, a $((Bi_{1-x}Pb_x)_{1-q}N_q)_2Sr_2Ca_2Cu_3O_z$ superconductor was prepared by formulating basic constituents: $Bi_2O_3$, PbO, SrO, CaO and CuO and a substituent N: $Sb_2O_3$, $As_2O_3$, $SnO_2$, $GeO_2$, $SiO_2$, $Tl_2O_3$, $In_2O_3$, $Ga_2O_3$ or $Al_2O_3$ at a $((Bi_{1-x}Pb_x)_{1-q}N_q)$:Sr:Ca:Cu ratio of 2:2:2:3, wherein x is 0.05, 0.1, 0.2, 0.3, 0.4, 0.5, 0.6, 0.7, 0.8, 0.9 or 1.0 and p is 0, 0.05, 0.1, 0.2, 0.3, 0.4 or 0.5, mixing the formulation in an attrition mill and pelletizing the mixture. These pellets were heat treated in air at 830-850°C for 50-240 hours to obtain the superconductor. The observation of the superconductor by an X-ray diffraction analysis revealed that an amount of foreign phases having unidentified peaks increased as the q value was raised but a major amount of crystals was the same Bi-(2223) phase as shown in Fig. 3. Furthermore, the measurements of resistance by a usual four-terminal method revealed that Tc ranged from 73-110 K for all the powders.

For a $((Bi_{1-x}Pb_x)_{1-q}N_q)_2Sr_2Ca_1Cu_2O_z$ superconductor, wherein substituent N was the same element as mentioned above, the same heat treatment as mentioned above resulted in the formation of a superconductor containing a major amount of the same crystal structure as $Bi_2Sr_2CaCu_2O_8$ and having a Tc of 68-90 K.

For a $((Bi_{1-x}Pb_x)_{1-q}N_q)_2Sr_2Cu_1O_z$ superconductor, wherein substituent N was the same element as mentioned above, the same heat treatment as mentioned above resulted in the formation of a superconductor containing a major amount of the same crystal structure as $Bi_2Sr_2CuO_6$ and having a Tc of 40-78 K.

Targets having various compositions (x = 0.2, p = 0.1 and q = 0.2) were made. Superconducting thin films were prepared with a laser vapor deposition method by using these targets in the same manner as in Example 1. The d and H* were measured in the same manner as in Example 1 and are shown in Table 2.

## Table 2

| M | Li | Na | K | Be | Mg | Sc | Y | La |
|---|---|---|---|---|---|---|---|---|
| d (Å) | 11.0 | 11.4 | - | 10.1 | 11.0 | 11.1 | 11.6 | 11.9 |
| H* (T) (T/Tc=0.6) | 4 | 3 | - | 7 | 4 | 4 | 3 | 2 |

| Ce | Pr | Nd | Pm | Sm | Eu | Gd | Tb | Dy | Ho |
|---|---|---|---|---|---|---|---|---|---|
| 11.8 | 11.8 | 11.8 | 11.7 | 11.7 | 11.7 | 11.7 | 11.6 | 11.6 | 11.6 |
| 2 | 2 | 2 | 3 | 3 | 3 | 3 | 3 | 3 | 3 |

| Er | Tm | Yb | Lu | Ag | Pt | Au | Pd | Ni |
|---|---|---|---|---|---|---|---|---|
| 11.5 | 11.5 | 11.5 | 11.4 | 11.7 | 10.5 | - | 10.5 | 11.0 |
| 3 | 3 | 3 | 3 | 3 | 5 | - | 5 | 4 |

| N | In | Ga | Al | Sn | Ge | Si | Sb | As | Tl |
|---|---|---|---|---|---|---|---|---|---|
| d (Å) | 11.4 | 10.8 | 10.7 | 11.1 | 10.5 | 10.4 | 11.4 | 10.8 | 11.5 |
| H* (T) (T/Tc=0.6) | 3 | 4 | 5 | 4 | 5 | 6 | 3 | 4 | 3 |

The same results as shown in Table 1 were obtained by alternative film-forming methods: a sputtering method and an MBE method.

Example 3

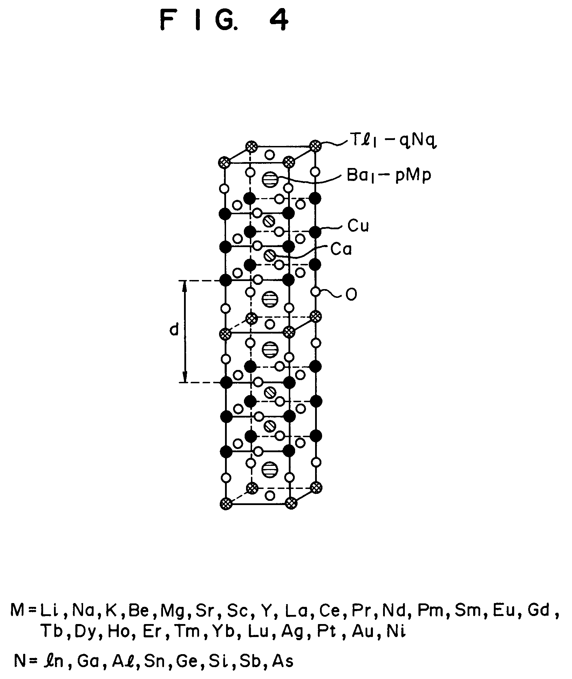

The model of the crystal structure of a superconductor represented by $Tl_1(Ba_{1-p}M_p)_2Ca_2Cu_3O_z$ is shown in Fig. 4. This superconductor was prepared in the following procedures. Basic constituent elements: $Tl_2O_3$, $BaO$, $CaO$ and $CuO$ and a substituent M: $Li_2O$, $Na_2O$, $K_2O$, $BeO$, $MgO$, $SrO$, $Sc_2O_3$, $Y_2O_3$, $La_2O_3$, $Ce_2O_3$, $Pr_2O_3$, $Nd_2O_3$, $Pm_2O_3$, $Sm_2O_3$, $Eu_2O_3$, $Gd_2O_3$, $Tb_2O_3$, $Ho_2O_3$, $Er_2O_3$, $Tm_2O_3$, $Yb_2O_3$, $Lu_2O_3$, $Ag_2O$, $Au$, $Pt$, $Pd$ or $Ni$ were formulated at a Tl: $(Ba_{1-p}M_p)$:Ca:Cu ratio of 1:2:2:3, wherein $0<p<1$. The thus obtained formulations were mixed in an attrition mill and pelletized. The resultant pellets were heat treated in air at 820-850°C for 50-240 hours to obtain superconductor powders. The observation of the powders by an X-ray diffraction analysis revealed that an amount of foreign phases having unidentified peaks increased as the p value was raised but a major amount of crystals was the same Tl-(1223) phase as shown in Fig. 4. Furthermore, the measurements of resistance by a usual four-terminal method revealed that Tc ranged from

8

82-115 K for all the powders.

For a $Tl_1(Ba_{1-p}M_p)_2Ca_1Cu_2O_z$ superconductor, wherein substituent M was the same element as mentioned above, the same heat treatment as mentioned above resulted in the formation of a superconductor containing a major amount of the same crystal structure as $TlBa_2CaCu_2O_7$ and having a Tc of 70-92 K.

For a $Tl_1(Ba_{1-p}M_p)_2Cu_1O_z$ superconductor, wherein substituent M was the same element as mentioned above, the same heat treatment as mentioned above resulted in the formation of a superconductor containing a major amount of the same crystal structure as $TlBa_2CuO_5$ and having a Tc of 50-90 K.

For a $Tl_1(Ba_{1-p}M_p)_2Ca_3Cu_4O_z$ superconductor, wherein substituent M was the same element as mentioned above, the same heat treatment as mentioned above resulted in the formation of a superconductor containing a major amount of the same crystal structure as $TlBa_2Ca_3Cu_4O_{11}$ and having a Tc of 70-90 K.

On the other hand, a $(Tl_{1-q}N_q)_1Ba_2Ca_2Cu_3O_z$ superconductor was prepared by formulating basic constituents: $Tl_2O_3$, BaO, CaO and CuO and a substituent N: $Sb_2O_3$, $As_2O_3$, $SnO_2$, $GeO_2$, $SiO_2$, $In_2O_3$, $Ga_2O_3$ or $Al_2O_3$ at a $(Tl_{1-q}N_q)$:Sr: Ca:Cu ratio of 1:2:2:3, wherein $0<q<1$, mixing the formulation in an attrition mill and pelletizing the mixture. These pellets were heat treated in air at 820-850°C for 50-240 hours to obtain the superconductor. The observation of the superconductor by an X-ray diffraction analysis revealed that an amount of foreign phases having unidentified peaks increased as the q value was raised but a major amount of crystals was the same Tl-(1223) phase as shown in Fig. 4. Furthermore, the measurements of resistance by a usual four-terminal method revealed that Tc ranged from 78-115 K for all the powders.

For a $(Tl_{1-q}N_q)_1Ba_2Ca_1Cu_2O_z$ superconductor, wherein substituent N was the same element as mentioned above, the same heat treatment as mentioned above resulted in the formation of a superconductor containing a major amount of the same crystal structure as $TlBa_2CaCu_2O_7$ and having a Tc of 70-90 K.

For a $(Tl_{1-q}N_q)_1Ba_2Cu_1O_z$ superconductor, wherein substituent N was the same element as mentioned above, the same heat treatment as mentioned above resulted in the formation of a superconductor containing a major amount of the same crystal structure as $TlBa_2CuO_5$ and having a Tc of 40-80 K.

For a $(Tl_{1-q}N_q)_1Ba_2Cu_4O_z$ superconductor, wherein substituent N was the same element as mentioned above, the same heat treatment as mentioned above resulted in the formation of a superconductor containing a major amount of the same crystal structure as $TlBa_2Ca_3Cu_4O_{11}$ and having a Tc of 70-90 K.

Targets having various compositions ($p=0.2$ and $q=0.1$) were made. Superconducting thin films were prepared with a laser vapor deposition method by using these targets in the same manner as in Example 1. The d and H* were measured in the same manner as in Example 1 and are shown in Table 3.

## Table 3

| M | Li | Na | K | Be | Mg | Sc | Y | La |
|---|---|---|---|---|---|---|---|---|
| d (Å) | 8.2 | 8.6 | 9.3 | 7.3 | 8.2 | 8.3 | 8.8 | 9.1 |
| H* (T) (T/Tc=0.6) | 35 | 20 | 10 | 71 | 35 | 33 | 14 | 13 |

| Ce | Pr | Nd | Pm | Sm | Eu | Gd | Tb | Dy | Ho |
|---|---|---|---|---|---|---|---|---|---|
| 9.0 | 9.0 | 8.9 | 8.9 | 8.9 | 8.9 | 8.9 | 8.8 | 8.8 | 8.7 |
| 13 | 13 | 14 | 14 | 14 | 14 | 14 | 14 | 14 | 15 |

| Er | Tm | Yb | Lu | Ag | Pt | Au | Pd | Sr | Ni |
|---|---|---|---|---|---|---|---|---|---|
| 8.7 | 8.7 | 8.6 | 8.6 | 8.9 | 7.7 | 9.4 | 7.6 | 9.2 | 8.2 |
| 15 | 15 | 18 | 18 | 14 | 56 | 9 | 60 | 11 | 35 |

| N | In | Ga | Al | Sn | Ge | Si | Sb | As |
|---|---|---|---|---|---|---|---|---|
| d (Å) | 10.3 | 9.7 | 9.6 | 9.9 | 9.3 | 9.2 | 10.2 | 9.6 |
| H* (T) (T/Tc=0.6) | 6 | 8 | 9 | 7 | 10 | 11 | 6 | 9 |

The same results as shown in Table 1 were obtained by alternative film-forming methods: a sputtering method and an MBE method.

Example 4

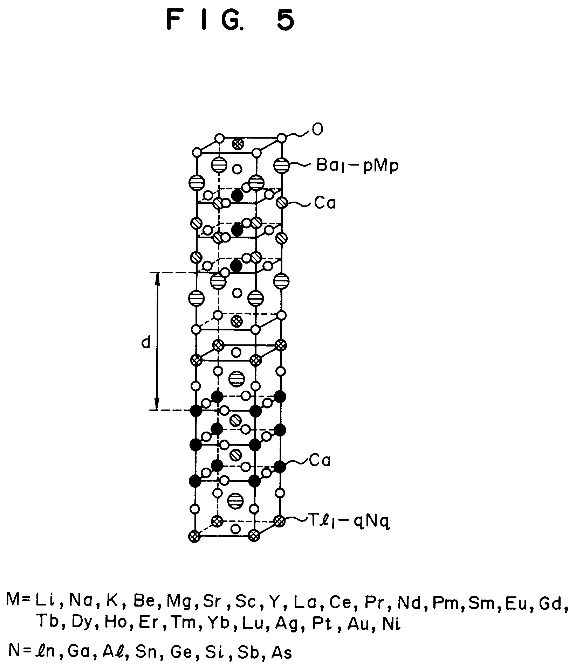

The model of the crystal structure of a superconductor represented by $Tl_2(Ba_{1-p}M_p)_2Ca_2Cu_3O_z$ is shown in Fig. 5. This superconductor was prepared in the following procedures. Basic constituent elements: $Tl_2O_3$, BaO, CaO and CuO and a substituent M: $Li_2O$, $Na_2O$, $K_2O$, BeO, MgO, SrO, $Sc_2O_3$, $Y_2O_3$, $La_2O_3$, $Ce_2O_3$, $Pr_2O_3$, $Nd_2O_3$, $Pm_2O_3$, $Sm_2O_3$, $Eu_2O_3$, $Gd_2O_3$, $Tb_2O_3$, $Ho_2O_3$, $Er_2O_3$, $Tm_2O_3$, $Yb_2O_3$, $Lu_2O_3$, $Ag_2O$, Au, Pt, Pd or Ni were formulated at a Tl: $(Ba_{1-p}M_p)$:Ca:Cu ratio of 2:2:2:3, wherein $0<p<1$. The thus obtained formulations were mixed in an attrition mill and pelletized. The resultant pellets were heat treated in air at 820-870°C for 10-80 hours to obtain superconductor powders. The observation of the powders by an X-ray diffraction analysis revealed that an amount of foreign phases having unidentified peaks increased as the p value was raised but a major amount of crystals was the same Tl-(2223) phase as shown in Fig. 5. Furthermore, the measurements of resistance by a usual four-terminal method revealed that Tc ranged from 82-125 K for all the powders.

For a $Tl_2(Ba_{1-p}M_p)_2Ca_1Cu_2O_z$ superconductor, wherein substituent M was the same element as mentioned above, the same heat treatment as mentioned above resulted in the formation of a superconductor containing a major amount of the same crystal structure as $Tl_2Ba_2CaCu_2O_8$ and having a Tc of 70-90 K.

For a $Tl_2(Ba_{1-p}M_p)_2Cu_1O_z$ superconductor, wherein substituent M was the same element as mentioned above, the same heat treatment as mentioned above resulted in the formation of a superconductor containing a major amount of the same crystal structure as $Tl_2Ba_2CuO_6$ and having a Tc of 40-80 K.

For a $Tl_2(Ba_{1-p}M_p)_2Ca_3Cu_4O_z$ superconductor, wherein substituent M was the same element as mentioned above, the same heat treatment as mentioned above resulted in the formation of a superconductor containing a major amount of the same crystal structure as $Tl_2Ba_2Ca_3Cu_4O_{12}$ and having a Tc of 70-90 K.

On the other hand, a $(Tl_{1-q}N_q)_2Ba_2Ca_2Cu_3O_z$ superconductor was prepared by formulating basic constituents: $Tl_2O_3$, BaO, CaO and CuO and a substituent N: $Sb_2O_3$, $As_2O_3$, $SnO_2$, $GeO_2$, $SiO_2$, $In_2O_3$, $Ga_2O_3$ or $Al_2O_3$ at a $(Tl_{1-q}N_q)$:Ba: Ca:Cu ratio of 2:2:2:3, wherein 0<q<1, mixing the formulation in an attrition mill and pelletizing the mixture. These pellets were heat treated in air at 820-850°C for 50-240 hours to obtain the superconductor. The observation of the superconductor by an X-ray diffraction analysis revealed that an amount of foreign phases having unidentified peaks increased as the q value was raised but a major amount of crystals was the same Tl-(2223) phase as shown in Fig. 5. Furthermore, the measurements of resistance by a usual four-terminal method revealed that Tc ranged from 78-125 K for all the powders.

For a $(Tl_{1-q}N_q)_2Ba_2Ca_1Cu_2O_z$ superconductor, wherein substituent N was the same element as mentioned above, the same heat treatment as mentioned above resulted in the formation of a superconductor containing a major amount of the same crystal structure as $Tl_2Ba_2CaCu_2O_8$ and having a Tc of 70-90 K.

For a $(Tl_{1-q}N_q)_2Ba_2Cu_1O_z$ superconductor, wherein substituent N was the same element as mentioned above, the same heat treatment as mentioned above resulted in the formation of a superconductor containing a major amount of the same crystal structure as $Tl_2Ba_2CuO_5$ and having a Tc of 40-80 K.

For a $(Tl_{1-q}N_q)_2Ba_2Ca_3Cu_4O_z$ superconductor; wherein substituent N was the same element as mentioned above, the same heat treatment as mentioned above resulted in the formation of a superconductor containing a major amount of the same crystal structure as $Tl_2Ba_2Ca_3Cu_4O_9$ and having a Tc of 70-90 K.

Targets having various compositions (p = 0.2 and q = 0.2) were made. Superconducting thin films were prepared with a laser vapor deposition method by using these targets in the same manner as in Example 1. The d and H* were measured in the same manner as in Example 1 and are shown in Table 4.

## Table 4

| M | Li | Na | K | Be | Mg | Sc | Y | La |
|---|---|---|---|---|---|---|---|---|
| d (Å) | 10.0 | 10.4 | 11.1 | 9.1 | 10.0 | 10.1 | 10.6 | 10.9 |
| H* (T) (T/Tc=0.6) | 8 | 6 | 4 | 13 | 8 | 8 | 5 | 4 |

| Ce | Pr | Nd | Pm | Sm | Eu | Gd | Tb | Dy | Ho |
|---|---|---|---|---|---|---|---|---|---|
| 10.8 | 10.8 | 10.7 | 10.7 | 10.7 | 10.7 | 10.7 | 10.6 | 10.6 | 10.5 |
| 4 | 4 | 5 | 5 | 5 | 5 | 5 | 5 | 5 | 6 |

| Er | Tm | Yb | Lu | Ag | Pt | Au | Pd | Sr | Ni |
|---|---|---|---|---|---|---|---|---|---|
| 10.5 | 10.5 | 10.4 | 10.4 | 10.7 | 9.5 | 11.2 | 9.4 | 11.0 | 10.0 |
| 6 | 6 | 6 | 6 | 5 | 9 | 3 | 11 | 4 | 8 |

| N | In | Ga | Al | Sn | Ge | Si | Sb | As |
|---|---|---|---|---|---|---|---|---|
| d (Å) | 11.0 | 10.4 | 10.3 | 10.7 | 10.1 | 10.0 | 11.0 | 10.4 |
| H* (T) (T/Tc=0.6) | 4 | 6 | 7 | 5 | 8 | 8 | 4 | 6 |

The same results as shown in Table 1 were obtained by alternative film-forming methods: a sputtering method and an MBE method.

Example 5

Two targets having compositions: (1) $(Tl_{0.6}Pb_{0.4})(Sr_{0.9}Na_{0.1})_2 Ca_2 Cu_3 O_z$ and (2) $SrTiO_3$ were prepared in the same manner as in Example 1. A film of $(Tl_{0.6}Pb_{0.4})(Sr_{0.9}Na_{0.1})_2 Ca_2 Cu_3 O_9$ of 100 nm thick was formed with the target (1) by the same laser vapor deposition method as in Example 1. Then, on this film was formed a film of $SrTiO_3$ of 30 nm thick with the target (2). Further on the $SrTiO_3$ film was formed a film of 100 nm with the target (1) to obtain a multilayer film. A pattern was formed on the multilayer film through a photoresist to form a Josephson junction which is used for SQUID and μ-wave appliances. The same Josephson element can be made through the same procedures from any one of the superconductors according to the present invention in place of the superconductor of the target (1) above.

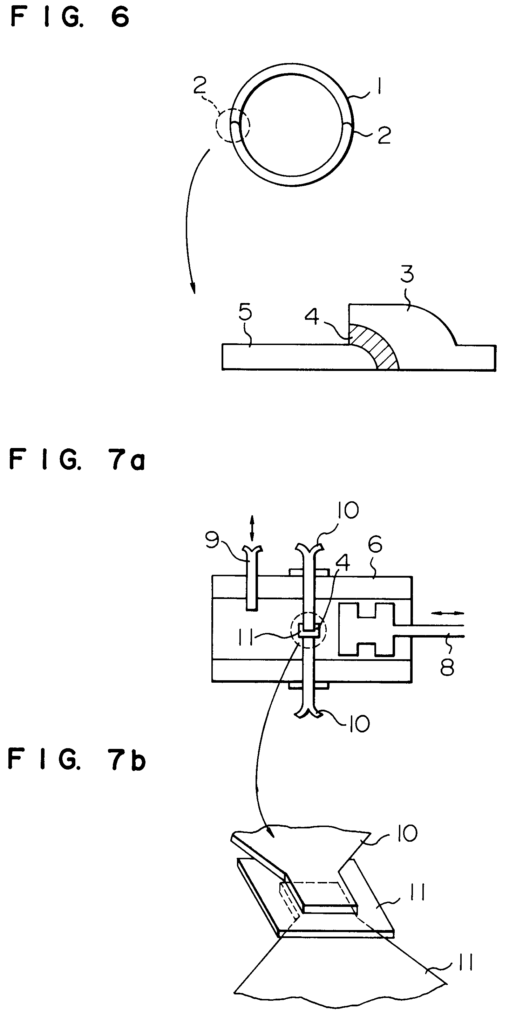

The construction of the SQUID element made above is shown in Fig. 6. It is a dc-SQUID 1 having two Josephson junctions 2, in which the upper and lower superconductors 3 and 5 both is of $(Tl_{0.6}Pb_{0.4})$

$(Sr_{0.9}Na_{0.1})_2Ca_2Cu_3O_9$ according to the present invention. As an intermediate layer 4 is used an insulating oxide of $SrTiO_3$. This SQUID element is assembled in a SQUID device. The measurement of a small magnetic field confirmed that a magnetic field was 1/100 Gauss at 77 K.

A waveguide mount of a $\mu$-wave detector made from the Josephson junction is shown in Fig. 7a and 7b. This waveguide mount was dipped in liquid nitrogen and the basic operation was confirmed. In Fig. 7, 6 is a waveguide mount of a $\mu$-wave detector, 7 a Josephson junction, 8 a choke plunger, 9 a stub plunger, and 11 and 12 upper and lower superconductors.

Example 6

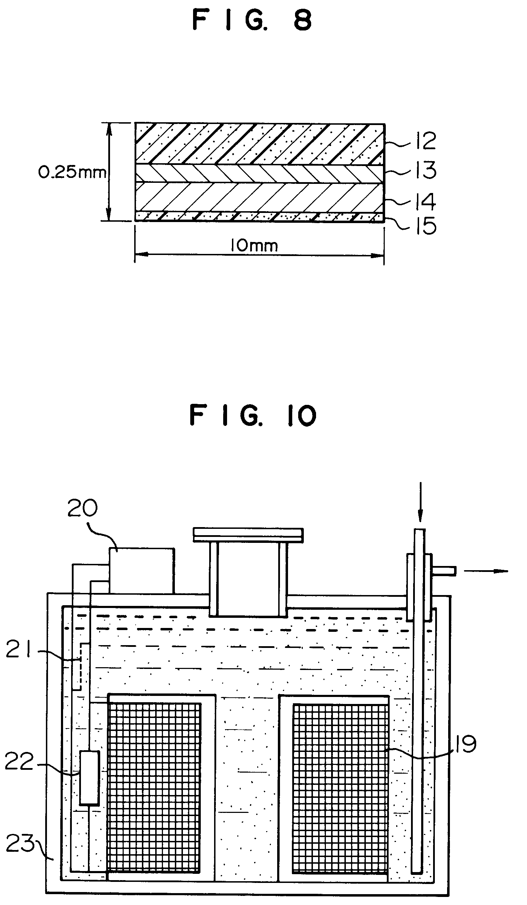

The cross-sectional view of a superconducting wire is shown in Fig. 8. The wire was prepared in the following manner. A superconductor thin film 12 of 0.1 mm thick was made on a composite metal tape of 10 mm wide comprising a silver tape 13 of 0.05 mm thick and a stainless steel tape 14 of 0.1 mm thick by coating a dispersion of $(Tl_{0.9}In_{0.1})(Ba_{0.9}Na_{0.1})_2Ca_2Cu_3O_9$ in an organic solvent with a doctor blade to obtain a wire. A thin nickel oxide layer 15 was formed on the tape for maintaining insulation of the tape when the wire was wound in a coil.

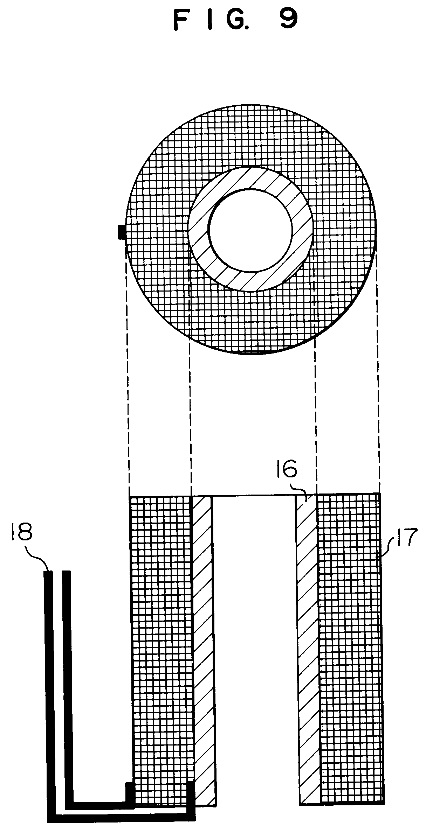

The coil with the superconducting wire above is shown in Fig. 9. The pancake-shaped coil 17 was manufactured by insulating the surface of a stainless steel-made cylindrical bobbin 16 of 45 mm in inner diameter, 50 mm in outer diameter and 100 mm in length, winding the wire above at 400 turns around the bobbin, and piling up 10 of the coils in a longitudinal direction. The whole coils were placed in an electric furnace and heat treated at 830°C for 30 hours.

Power-supplying lead 18 made of copper was connected to the outside of the coils at the uppermost and lowermost portions thereof.

The superconducting coils were assembled in such a coil system as shown in Fig. 10 to make a magnet. To the magnet was supplied an external power in a state cooled with liquid nitrogen. A magnetic field of at least 2.1 tesler was produced by the coil system.

Example 7

An NMR device was manufactured with the magnet manufactured in Example 6. The nuclear magnetic resonance of hydrogen atoms was determined by the NMR device. The insulating system of this NMR device could be simplified over conventional, commercially available NMR devices operated with helium. Therefore, the production cost was reduced by 10 % or more. Since this device does not use expensive helium, the running cost could be reduced to a large extent.

Since an NMR device and MRI device are identical in the fundamental operation principle, it is clearly possible to manufacture a MRI device from a superconducting magnet with the superconducting wire according to the present invention. The production cost was estimated to find that it can be reduced by at least 20 %, because a liquid nitrogen refrigerator can be replaced with a liquid helium refrigerator.

Example 8

The cost of producing a magnetic levitation vehicle with the superconducting wire according to the present invention was estimated. It was found that the vehicle had an improved reliability and the production cost was reduced by at least 5 %, because a more simple and cheaper liquid nitrogen refrigerator could be used in place of a liquid helium refrigerator.

Example 9

A magnetic shield using the superconductor according to the present invention. A cubic body was made from plates of the superconductor of 3 cm thick and cooled with liquid nitrogen at 78 K. To this was externally applied a magnetic field of 50 Gauss in a shielded superconducting state. The magnetic field in the cubic body was measured with a hole element placed in the cubic body. It was too small to be detected with the hole element. When the externally applied magnetic field was 3,000 Gauss, the detected magnetic field in the cubic body was about 1 Gauss. Thus, the superconductor according to the present invention exhibited an adequate magnetic shielding property.

Example 10

In replacing all quadrupole magnets for convergence of particle beam attached to a large-sized particle accelerator, e.g., an accelerator ring of 1 km in diameter, with the magnets made from the superconducting wire according to the present invention, our estimated costs with a liquid nitrogen refrigerator are lower by 20% or more than the costs incurred with a conventional liquid helium refrigerator, because the liquid nitrogen refrigerator is much simpler in the structure, easier and better in the insulation system, and much simpler in the system for supplying a coolant to the superconducting magnet than the liquid helium refrigerator. This is because liquid nitrogen as the coolant has a higher specific heat.

**Claims**

1. An oxide superconductor of a layered perovskite structure containing Cu-O planes, which has the longest distance d between the Cu-O planes of 0.3 nm or more but less than 0.9 nm ($0.3$ nm $\leq d < 0.9$ nm) in the crystal structure of said superconductor, the magnitude of a superconducting current flowing through said superconductor over the grain boundaries formed between the crystal grains of said superconductor being 1/5 or more of the magnitude of a superconducting current flowing within said crystal grains.

2. An oxide superconductor of a layered perovskite structure containing Cu-O planes, which has the longest distance d between the Cu-O planes of 0.3 nm or more but less than 0.9 nm ($0.3$ nm $\leq d < 0.9$ nm) in the crystal structure of said superconductor, the magnitude of a superconducting current flowing through said superconductor over the grain boundaries formed between the crystal grains of said superconductor being 10,000 A/cm$^2$ at a temperature of 77 K and a magnetic field of 1 tesler.

3. An oxide superconductor of a layered perovskite structure containing Cu-O planes, which has the longest distance d between the Cu-O planes of 0.3 nm or more but less than 0.9 nm, the number of oxygen atoms going into or coming from said superconductor being 0.5 per unit lattice.

4. An oxide superconductor of a layered perovskite structure containing Cu-O planes, which is derived from a starting superconductor $(Tl_{1-x}Pb_x)$-$Sr_2$-$Ca_y$-$Cu_{y+1}$-$O_z$, wherein $0 < x < 1$, $0 \leq y \leq 3$ and $3 + 2y < z < 4 + 2y$, the longest distance d between the Cu-O planes of said superconductor derived by substituting for one or more constituents of Tl, Pb, Sr and Ca in said superconductor elements having a smaller ionic radius than that of said constituents, being smaller than the longest distance $d_0$ between the Cu-O planes of said starting superconductor.

5. An oxide superconductor of a layered perovskite structure containing Cu-O planes, which is derived from a starting superconductor $Tl_1$-$Ba_2$-$Ca_y$-$Cu_{y+1}$-$O_z$, wherein $0 \leq y \leq 3$ and $3 + 2y < z < 4 + 2y$, the longest distance d between the Cu-O planes of said superconductor derived by substituting for one or more constituents of Tl, Ba and Ca in said superconductor elements having a smaller ionic radius than that of said constituents, being smaller than the longest distance $d_0$ between the Cu-O planes of said starting superconductor.

6. An oxide superconductor of a layered perovskite structure containing Cu-O planes, which is derived from a starting superconductor $Tl_2$-$Ba_2$-$Ca_y$-$Cu_{y+1}$-$O_z$, wherein $0 \leq y \leq 3$ and $5 + 2y < z < 7 + 2y$, the longest distance d between the Cu-O planes of said superconductor derived by substituting for one or more constituents of Tl, Ba and Ca in said superconductor elements having a smaller ionic radius than that of said constituents, being smaller than the longest distance $d_0$ between the Cu-O planes of said starting superconductor.

7. An oxide superconductor of a layered perovskite structure containing Cu-O planes, which is derived from a starting superconductor $(Bi_{1-x}Pb_x)_2$-$Sr_2$-$Ca_y$-$Cu_{y+1}$-$O_z$, wherein $0 < x < 1$, $0 \leq y \leq 2$ and $5 + 2y < z < 7 + 2y$, the longest distance d between the Cu-O planes of said superconductor derived by substituting for one or more constituents of Bi, Sr and Ca in said superconductor elements having a smaller ionic radius than that of said constituents, being smaller than the longest distance $d_0$ between the Cu-O planes of said starting superconductor.

14

8. The oxide superconductor according to claim 2 or 7, wherein for Sr of said starting superconductor is substituted an alkali metal such as Li and Na, alkaline earth metal such as Be, Mg or Sr, Group IIIa metal such as Sc, Y or Ln (lanthanoids) or Ag, Pt, Au, Pd or Ni, or combinations thereof, the substitution being made at a rate of 1-30% based on the total of Sr.

9. The oxide superconductor according to claim 5 or 6, wherein for Ba of said starting superconductor is substituted an alkali metal such as Li or Na, alkaline earth metal such as Be, Mg or Sr, Group IIIa metal such as Sc, Y or Ln (lanthanoids) or Ag, Pt, Au, Pd or Ni, or combinations thereof, the substitution being made at a rate of 1-30% based on the total of Ba.

10. The oxide superconductor according to claim 4, 5 or 6, wherein for Tl or Pb of said starting superconductor is substituted a Group IIIb metal such as In, Ga or Al, Group IVb metal such as Sn, Ge or Si or Group Vb metal such as Sb or As, or combinations thereof, the substitution being made at a rate of 1-30% based on the total of Tl and Pb.

11. The oxide superconductor according to claim 7, wherein for Bi or Pb of said starting superconductor is substituted a Group IIIb metal such as In, Ga or Al, Group IVb metal such as Sn, Ge or Si or Group Vb metal such as Sb or As, or combinations thereof, the substitution being made at a rate of 1-30% based on the total of Bi and Pb.

12. A superconducting wire comprising the oxide superconductor according to any one of claims 1 to 11.

13. A magnet using the superconducting wire comprising the oxide superconductor according to any one of claims 1 to 11.

14. An NMR device using the magnet using the superconducting wire comprising the oxide superconductor according to any one of claims 1 to 11.

15. An MRI device using the magnet using the superconducting wire comprising the oxide superconductor according to any one of claims 1 to 11.

16. A magnetic levitation vehicle using the magnet using the superconducting wire comprising the oxide superconductor according to any one of claims 1 to 11.

17. A generator using the superconducting wire comprising the oxide superconductor according to any one of claims 1 to 11.

18. An energy storage device using the superconducting wire comprising the oxide superconductor according to any one of claims 1 to 11.

19. A magnetic shield using the superconducting wire comprising the oxide superconductor according to any one of claims 1 to 11.

20. A synchrotron using the superconducting wire comprising the oxide superconductor according to any one of claims 1 to 11.

21. A magnetic separator using the magnet using the superconducting wire comprising the oxide superconductor according to any one of claims 1 to 11.

22. An elementary particle accelerator using the magnet using the superconducting wire comprising the oxide superconductor according to any one of claims 1 to 11.

23. A SQUID element using the oxide superconductor according to any one of claims 1 to 11.

24. A μ-wave detector using the SQUID element using the oxide superconductor according to any one of claims 1 to 11.

# F I G. I

$(T\ell/Pb)_{1-q}N_q$

$Sr_{1-p}M_p$

Ca

Cu

O

d

M = Li, Na, Be, Mg, Sc, Y, La, Ce, Pr, Nd, Pm, Sm, Eu, Gd, Tb,
    Dy, Ho, Er, Tm, Yb, Lu, Ag, Pt, Pd, Ni

N = $\ell$n, Ga, A$\ell$, Sn, Ge, Si, Sb, As

# F I G. 2

$Y_1Ba_2Cu_3O_z$

T/Tc = 0.6

$(T\ell rxPbx)Sr_2Ca_2Cu_3O_z$

$T\ell_1Ba_2Ca_2Cu_3O_z$

$T\ell_2Ba_2Ca_2Cu_3O_z$

$Bi_2Sr_2Ca_1Cu_2O_z$

$H^{*}(T)$

d

## F I G. 3

Labels in figure: O, $Sr_{1-p}M_p$, Ca, Cu, d, $(Bi/Pb)_{1-q}N_q$

M = Li, Na, Be, Mg, Sc, Y, La, Ce, Pr, Nd, Pm, Sm, Eu, Gd, Tb, Dy, Ho, Er, Tm, Yb, Lu, Ag, Pt, Pd, Ni

N = In, Ga, Al, Sn, Ge, Si, Sb, As, Tl

# F I G. 4

Labels in figure: $Tl_{1-q}N_q$, $Ba_{1-p}M_p$, Cu, Ca, O, d

M = Li, Na, K, Be, Mg, Sr, Sc, Y, La, Ce, Pr, Nd, Pm, Sm, Eu, Gd,
Tb, Dy, Ho, Er, Tm, Yb, Lu, Ag, Pt, Au, Ni

N = ℓn, Ga, Aℓ, Sn, Ge, Si, Sb, As

# FIG. 5

M = Li, Na, K, Be, Mg, Sr, Sc, Y, La, Ce, Pr, Nd, Pm, Sm, Eu, Gd,
Tb, Dy, Ho, Er, Tm, Yb, Lu, Ag, Pt, Au, Ni

N = ℓn, Ga, Aℓ, Sn, Ge, Si, Sb, As

FIG. 6

FIG. 7a

FIG. 7b

# F I G. 8

0.25mm

10mm

12
13
14
15

# F I G. 10

20

21

22

23

19

# F I G. 9

European Patent
Office

EUROPEAN SEARCH REPORT

Application Number

EP    93 10 4942
Page 1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | PHYSICA C vol. 159, no. 6, 1 August 1989, AMSTERDAM, NL pages 801 - 810 Gai, P.L. et al 'Microstructure and microchemistry of defects and interfaces in Tl2Ba2Ca3Cu4O12, TlBa2Ca4Cu5O13 and (Tl,Pb)Sr2Can-1CunO2n+3 (n=2,3) oxide superconductors' * page 804, paragraph 1 - page 807, paragraph 2 * | 1,3-6 | H01L39/24 |
| A | PHYSICA C vol. 161, no. 3, 15 November 1989, AMSTERDAM, NL pages 390 - 402 Zandbergen, H.W. et al 'High resolution electron microscopy on grain boundaries in Pb2Sr2-xLaxCu2O6+ delta Pb2(Sr,La)2SrCu3O8+ delta and Pb2Sr2(Ca,Y)Cu3O8+ delta' * page 397, paragraph 2 - page 399, paragraph 1 * | 1-3 | |
| A | PHYSICA C, vol.185, pt.4, 01 December 1991, pages 2281-2282, Amsterdam, NL; Matsuda S.P. et al:"Introduction of pinning centers into Tl-Sr-Ca-Cu-O systems" * page 2281 - page 2282 * | 1-24 | TECHNICAL FIELDS SEARCHED (Int. Cl.5 ) <br><br> H01L |

-/--

The present search report has been drawn up for all claims

| Place of search | Date of completion of the search | Examiner |
|---|---|---|
| THE HAGUE | 22 JUNE 1993 | HAMMEL E.J. |

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | APPLIED PHYSICS LETTERS vol. 59, no. 24, 9 December 1991, NEW YORK, US pages 3186 - 3188 Kamo T. et al 'Introduction of pinning centers into Tl-(1223) phase of Tl-Sr-Ca-Cu-O systems' * page 3186 - page 3188 * | 1-24 | |
| A | EP-A-0 443 827 (HER MAJESTY THE QUEEN IN RIGHT OF NEW ZEALAND) * page 2, line 39 - page 3, line 16 * * claims 1-9 * | 1-6, 12-24 | |
| D,A | PHYSICA C vol. 177, no. 4, 1 July 1991, AMSTERDAM, NL pages 431 - 437 Kim D.H. et al 'Effect of Cu-O layer spacing on the magnetic field induced resistive broadening of high-temperature superconductors' * page 431 - page 433 * | 1-6 | TECHNICAL FIELDS SEARCHED (Int. Cl.5) |

The present search report has been drawn up for all claims

| Place of search | Date of completion of the search | Examiner |
|---|---|---|
| THE HAGUE | 22 JUNE 1993 | HAMMEL E.J. |

EPO FORM 1503 03.82 (P0401)